# EUROPEAN PATENT APPLICATION

(11) **EP 4 443 734 A1**
(43) Date of publication of application: **09.10.2024**
(21) Application number: 23167079.5
(22) Date of filing: 06.04.2023
(51) Int. Cl.: H02M 7/483, H02M 7/487, H02M 7/00, H02M 1/00, G01R 15/14

(54) **SHOOT-THROUGH PROTECTION AND CURRENT MONITORING SCHEME FOR MULTILEVEL POWER CONVERTERS**

(71) Applicant: Hamilton Sundstrand Corporation, Charlotte, NC 28217 (US)
(72) Inventor: POPEK, Grzegorz, Birmingham, B14 5QH (GB); KULSANGCHAROEN, Ponggorn, Solihull, B90 3ET (GB)
(74) Representative: Dehns

(57) **Abstract**

A multilevel power converter comprising: a DC bus having a positive terminal and a negative terminal; a plurality of switches (3a, 3b, 3c, 3d) for each of a plurality of phase legs of the power converter connected between the positive terminal and the negative terminal, each power leg having an output for provided a converted voltage output according to the switching control of the plurality of switches; and wherein a current sensor (4) provided in each phase leg connected in series between an adjacent pair (3a, 3b) of the plurality of switches.

## Description

### TECHNICAL FIELD

The present disclosure relates to providing shoot-through protection and current monitoring for multilevel power converters.

### BACKGROUND

Power converters are used in many fields to convert one form of power to another to drive one or more loads. For example, power converters may convert ac power to one or more levels of dc power output or may convert one level of dc power to one or more other levels of dc output as required by the load(s) to be driven.

Multilevel power converters were developed to provide multiple voltage levels at the converter output and are able to reach higher dc link voltage levels. More recent developments in multilevel power converter design has resulted in improved efficiency, lower dv/dt leading to lower EMI effects, reduced transmission line effects and improved input power quality. Multilevel power converters comprise a plurality of converter modules including semiconductor switches. In isolated power converters, isolated modules are connected in series. Various power converter topologies (e.g. T-type, H-type, etc.) are known. Non-isolated power converters are also known, with various topologies including 'diode neutral point clamp' (DNPC), T-type neutral point clamp' (TNPC), active neutral point clamp' (ANPC) and with flying capacitors. The switches in the modules each require a power supply or gate driver circuit and insulation barriers are required between the different modules.

As multilevel power converters get more complex, with more levels, the risk of a switch being faulty and causing an open circuit or short circuit fault increases. If multiple modules are 'on' at the same time, this can result in a surge of current through the circuit (shoot-through). The current through the power converter therefore needs to be monitored to detect a dc link short circuit or 'shoot-through'.

The current is typically sensed by current sensors e.g. resistors in each of the output lines and these current sensors also require power.

While such multilevel power converters have been found to be efficient and reliable, there is a desire for an improved power converter scheme which is simpler than current designs and has reduced power supply and insulation barrier requirements whilst still reliably monitoring current and protecting against shoot-through.

### SUMMARY

According to this disclosure, there is provided a multilevel power converter comprising: a DC bus having a positive terminal and a negative terminal; a plurality of switches for each of a plurality of phase legs of the power converter connected between the positive terminal and the negative terminal, each power leg having an output for provided a converted voltage output according to the switching control of the plurality of switches; and wherein a current sensor provided in each phase leg connected in series between an adjacent pair of the plurality of switches

### BRIEF DESCRIPTION

Examples of the multilevel power converter scheme according to the disclosure will be described with reference to the drawings. It should be noted that variations are possible within the scope of the claims. For example, the drawings and description present the solution in relation to a three-level T-type power converter topology but this is only one example, and the solution of the disclosure can also be applied to other multilevel power converter topologies.
Figure 1 is a schematic diagram of a circuit topology of a known three-phase three-level T-type power converter.
Figure 2 is a schematic diagram of a circuit topology of a three-phase three-level T-type power converter incorporating shoot-through protection and current monitoring according to the disclosure.

### DETAILED DESCRIPTION

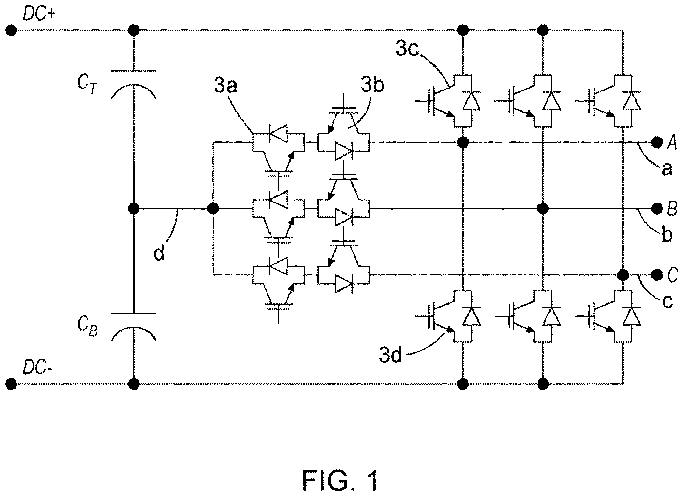

The general operation and different possible topologies of multilevel power converters are now well-known and well understood. Power semiconductor switches are arranged as modules in phase legs and the switches are switched on and off according to a control scheme to provide the required multiple level outputs. One popular topology for a multilevel power converter is a three-phase three-level T-type topology such as shown in Fig. 1, where each phase leg consists of power switches 3a, 3b, 3c and 3d. For the positive voltage phase, the first switch, 3a, is always on, switches 3b and 3c switch on and off in a complementary fashion and switch 3d is off. For the negative voltage phase, switch 3b is permanently on, switches 3a and 3d work as a complementary pair and 3c is off. This operation provides the step-wise voltage used to provide the multiple output levels. The control of the switches is coordinated by a controller and the switches are switched by their respective gate drivers (not shown). The topology shown here is for a three-level converter and provides three different levels at the outputs A, B and C. Multilevel converters having more than three levels and also more than three phases e.g. five-phase, seven-phase etc., are also known.

Typically, to monitor current in the circuit, current sensors are provided at each of the three phase output lines a, b, c (the current sensors are not shown here in Fig. 1). These current sensors, whilst monitoring the power converter output, are not able to detect current flow back into the switches - i.e. do not detect switch faults - and this is a common problem that can destroy the converter. In another solution described in US 11,119,159 B2, a current sensor is provided at the input to the phase leg switch arrangement (indicated by 'd' in Fig. 1). The problem of shoot-through is typically addressed by the incorporation of desaturation functions in the gate driver circuits for each module. This function involves, when saturation happens, informing the gate driver circuit and the gate driver circuit then takes action by stopping all switching.

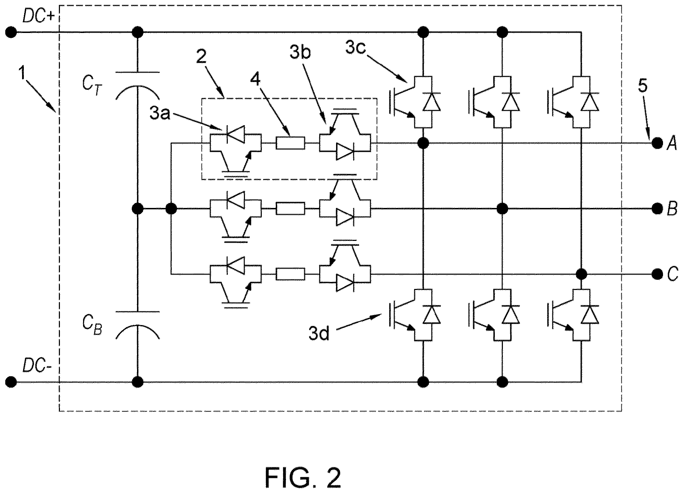

The solution provided by this disclosure, an example of which is shown in Fig. 2, is to provide current sensors 4 in the phase leg branch 2, between two series-connected switches. The current sensors are preferably in the form of shunt resistors. The current sensors 4 are able to detect whether the switching waveform is different from what would be expected during normally controlled switching.

Further, the current sensor 4 is able to act as a current sampler and is able to reconstruct the output phase current. Additionally, because the current sensor is in the switch module 2 it can use power from the same power supply as is used to drive the switches 3a and 3b. The current sensor/resistor is also able to share the isolation barriers with the switches (here 3a and 3b). The known solutions mentioned above do not enable this shared power supply.

Explained in more detail, the voltage drop across the current sensor (e.g. shunt resistor 4) is proportional to the commutation current in the branch 2. The phase load current 5 at the output that needs to be measured for control purposes will always flow through either the positive (3c) or the negative (3d) switches and so will partially flow through the branch 2 where the shunt resistor 4 is located. The current sensor 4 therefore effectively sees a sampled and hold version of the load current 5 and is then able to reconstruct the full shape of the load current 5 by measuring the partial current from the voltage drop across the sensor/resistor 4.

Further, as mentioned above, the sensor 4 can share the power supply and isolation barriers with the switches operating in common source/emitter configuration. This greatly simplifies the design of the layout and reduces the amount of auxiliary circuitry required.

Further, because the current sensor/shunt resistor 4 directly measures the current flowing through the capacitors C_{T} and C_{B}, it also serves as a reliable shoot-through protection for those capacitors so instead of 12 desaturation circuits being required (one for each switch) in a three-phase three-level T-type converter, only three (one for each branch 2) are required.

If the current sensor detects a fault in the circuit, the output from that sensor will be taken by the control circuit to stop operation of the converter to prevent damage.

## Claims

1. A multilevel power converter comprising:
a DC bus having a positive terminal and a negative terminal;
a plurality of switches (3a, 3b, 3c, 3d) for each of a plurality of phase legs of the power converter connected between the positive terminal and the negative terminal, each power leg having an output for provided a converted voltage output according to the switching control of the plurality of switches;
and wherein
a current sensor (4) provided in each phase leg connected in series between an adjacent pair (3a, 3b) of the plurality of switches.

2. The multilevel power converter of claim 1, wherein the current sensor (4) in each phase leg is a shunt resistor.

3. The multilevel power converter of claim 1 or 2, wherein in each phase leg the current sensor and the pair of adjacent switches share a common power supply.

4. The multilevel power converter of claim 1 or 2, wherein in each phase leg the current sensor and the pair of adjacent switches share a common isolation boundary.

5. The multilevel power converter of any preceding claim being a T-type power converter having, for each phase leg, first and second switches (3a, 3b) connected in series between the positive and the negative terminal, a third switch (3c) between the series connected first and second switches and the positive terminal and a fourth switch (3d) connected first and second switches and the negative terminal.

6. The multilevel power converter of any of claims 1 to 4, being an H-bridge power converter.

7. The multilevel power converter of any preceding claim, being a three-level power converter.

8. The multilevel power converter of any of claims 1 to 5, having more than three levels.

9. The multilevel power converter of any preceding claim having first and second capacitors connected in series across the positive and negative terminals and wherein the switches of all phase legs are connected to a mid-point between the first and second capacitors.

10. The multilevel power converter of any preceding claim further comprising a controller for controlling switching of the plurality of switches.

11. The multilevel power converter of claim 10, wherein the controller is a pulse width modulator, PWM, controller.
